# EUROPEAN PATENT APPLICATION

(11) **EP 1 932 941 A1**
(43) Date of publication of application: **18.06.2008**
(21) Application number: 07122918.1
(22) Date of filing: 11.12.2007
(51) Int. Cl.: C23C 16/44, B08B 7/00

(54) **Thermal etch process for cleaning CVD chambers**

(30) Priority: 13.12.2006 US 638120
(71) Applicant: Air Products and Chemicals, Inc., Allentown, PA 18195-1501 (US)
(72) Inventor: Johnson, Andrew David, Doylestown, PA 18901 (US); Maroulis, Peter James, Alburtis,, PA 18011 (US); Vorsa, Vasil, Coopersburg, PA 18036 (US); Ridgeway Robert Gordon, Quakertown,, PA 18951 (US)
(74) Representative: Muir, Benjamin M. J.

(57) **Abstract**

Equipment surfaces in a semiconductor processing chamber are cleaned of undesired silicon nitride by flowing fluorine diluted in an inert gas through the chamber maintained at an elevated temperature of 230 °C to 565 °C to thermally disassociate the fluorine, thereby cleaning undesired silicon nitride from the surfaces by chemical reaction of thermally disassociated fluorine in (b) with the undesired silicon nitride to form volatile reaction products; and removing the volatile reaction products from the chamber.

## Description

### BACKGROUND OF THE INVENTION

Low-pressure chemical vapor deposition (LPCVD) plays a critical role as part of sequence of steps in the fabrication of complementary metal oxide semiconductor (CMOS) integrated circuits. Silicon nitride is typically deposited in LPCVD by reacting dichloro-silane (DCS) and ammonia in a hot-wall reactor. The primary driving force for the reaction is the thermal energy from the reactor that can operate at temperatures between 650 - 850 °C. However, as technology nodes proceed from 130 nm to 32 nm, the thermal budget becomes a serious problem. To circumvent this problem, new LPCVD precursors that require less thermal energy to react are being introduced. For example, as an alternative to using DCS and ammonia to deposit silicon nitride films at 700 °C, processes in which organic amine substituted silanes, such as Bis(Tertiary Butyl Amino) silane (BTBAS), diisopropyl amine silane (DIPAS), and diethyl amine silane (DEAS), or organic substituted silanes, such as tetra allyl silane, and trivinyl silane with bis-tertiary butyl amino silane, are reacted with ammonia at 600 °C or a lower temperature are gaining favor, because they significantly reduce thermal budgets. Silicon nitride films produced by these processes not only deposit on the wafer, but also on the walls of the quartz reactor and reactor components. Moreover, the nitride films produced by these processes have high tensile stresses which can lead to high levels of particle contamination of device wafers from film spalling due to cumulative deposits in the reactor. In order to prevent wafer contamination, nitride furnaces must be cleaned before the cumulative deposits start spalling. Higher stress films require more frequent cleaning of the LPCVD reactor and wafer holder due to particle generation caused by the film spalling.

The current practice is to manually clean the LPCVD reactor of silicon nitride deposits by cooling the quartz tubes to room temperature, then removing them and placing them into a wet HF (Hydrogen Fluoride) etch. In all, the wet clean procedure requires 8 to 6 hours of equipment downtime. Compared to a DCS nitride furnace that only requires cleaning after 60 to 90 days of production, BTBAS nitride furnaces typically require cleaning after every two days of operation. Thus, for the aforementioned organic amine substituted silane or organic substituted silane nitride process to be practical in high volume semiconductor manufacturing, an in-situ clean with a 2-3 hour cycle time is required. Moreover, deposition of organic amine substituted silanes or organic substituted silanes requires temperatures in the range of 500 - 600°C. Therefore, a clean time which is a function of reactor temperatures in the range of 500 °C to 600 °C becomes increasingly important.

D. Foster, J. Ellenberger, R.B. Herring, A.D. Johnson, and C.L. Hartz, "In-situ process for periodic cleaning of low temperature nitride furnaces," in Proceedings of the 204th Meeting of the Electrochemical Society, Orlando FL (The Electrochemical Society, Inc., Pennington, NJ, October 2003) p. 285-293, discloses the use of 20% NF₃ to etch SiNₓ in a temperature range of 500 - 600 °C, but the etch rate is relatively slow (0.02 µm /min at 550°C and 30Torr (4kPa)).

For the aforementioned organic amine substituted silane or organic substituted silane nitride process to be practical in high volume semiconductor manufacturing, a more efficient cleaning method with lower thermal activation temperatures in the range of 500 °C to 600 °C is needed.

### BRIEF SUMMARY OF THE INVENTION

One embodiment of a method according to the current invention comprises flowing fluorine diluted in an inert gas through the chamber and maintaining the chamber at an elevated temperature of 230 °C to 565 °C to thermally disassociate the fluorine, thereby cleaning the CVD chambers by removing the volatile reaction products, such as SiF₄, formed by the chemical reaction of thermally activated fluorine with the undesired silicon nitride. According to another embodiment of the invention, an elevated temperature of 450°C to 550°C is used.

### BRIEF DESCRIPTION OF SEVERAL VIEWS OF THE DRAWINGS

Figure 1 is a schematic illustration of an experimental apparatus for use in demonstrating an embodiment of the thermal F₂ cleaning process of the present invention.
Figure 2 is a graph showing the thermal F₂ etch rate of silicon nitride by pre-diluted 20% F₂ in N₂ as a function of temperature at 30 torr (4 kPa).
Figure 3 is a graph showing the thermal NF₃ etch rate of silicon nitride by pre-diluted 20% NF₃ in N₂ as a function of temperature at 30 torr (4 kPa).

### DETAILED DESCRIPTION OF THE INVENTION

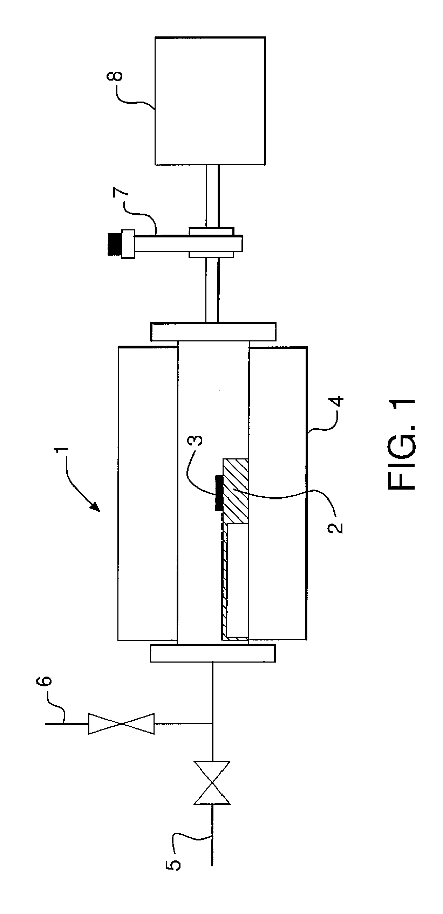

A schematic diagram of an experimental apparatus for use in demonstrating an embodiment of the current invention is shown in Figure 1. Reactor tube 1, which is made out of nickel 201 alloy, has stainless steel conflat flange ends welded to the ends thereof. The tube outer diameter ("O.D") is 2¼" (5.5 cm) and contains a 6 in X 1.5 in (15 x 4 cm) nickel tray 2 that holds a silicon nitride wafer coupon 3 in the middle of the tube. The tray 2 is inserted at the end of the tube 1 by removing the conflat flange. The reactor tube 1 is surrounded by a furnace 4, manufactured by Advanced Temperature Systems, containing a heater used to elevate the temperature of the sample. The reactor temperature is controlled by a Watlow PID controller. Molecular fluorine 5 is introduced into the reactor by flowing pre-diluted F₂ in N₂ from a high pressure cylinder at a flow rate of 50 or 100 sccm. The flow is controlled by a STEC model 3400 heated mass flow controller (MFC). The reactor is purged with pure nitrogen 6 before and after each experiment. Reactor tube pressure is measured with a heated (100°C) capacitance manometer (1000 torr (130 kPa)) manufactured by MKS systems. The pressure is controlled manually by adjusting the pumping speed of the system with the gate valve 7 at the output side of the reactor. An Alcatel two-stage rotary pump 8 is used to pump the system.

Silicon nitride wafers were produced by depositing with DCS an approximately 1 micron thick silicon nitride film on a layer of SiO₂. The silicon nitride wafers were cleaved into small 2 cm by 2 cm coupons. Prior to placing a coupon into the reactor, the samples were first cleaned in an ammonia-peroxide solution (RCA-1 clean) at 70°C for 10 minutes to remove any organic contamination. The coupons were then placed into a 0.5% HF solution for 5 - 10 seconds to remove any surface oxides that may have built up. The samples were then rinsed, dried and placed into the reactor.

The silicon nitride coupons are placed in the middle of the thermal reactor on a tray with one end slightly elevated (∼5 mm) off of the tray and the face of the coupon parallel to the gas flow. The end of the reactor tube is then sealed by replacing the conflat vacuum flange. Several pump/vacuum cycles are performed to remove atmospheric gases from the reactor. The reactor is then purged with 100 sccm of nitrogen. Once the chamber is purged, the furnace 4 is turned on and is programmed to reach operating temperature in 2 hours. Once the furnace reaches the set temperature, two additional hours are used to ensure the internal temperature reaches the target. The internal temperature is monitored with a thermal couple well that sticks into the chamber. Once the internal temperature of the reactor is at its target, the nitrogen valve is closed and the system is allowed to pump down to <100 mtorr (13 Pa). After the base vacuum level is reached, pre-diluted fluorine is introduced into the reactor by opening the fluorine valve. The wafer is then etched anywhere from 1 minute for the more aggressive etches (higher temperatures and pressures) to over 10 minutes for the less aggressive etches (lower temperatures and pressures). The etch is stopped by closing the fluorine valve and immediately opening gate valve 7 to fully evacuate the chamber and allowing the volatile reaction products to be completely pumped out from the chamber. The etch time is determined by the length of time that the silicon nitride is exposed to the fluorine gas. The reactor is then allowed to cool before the sample coupon is removed. In the real operation environment, the etching and the cleaning are performed in the typical operation conditions.

Silicon nitride samples were analyzed by reflectometry before and after etching to determine etch rate through change in film thickness. The etch rate is then calculated by dividing the change in thickness of material in nanometers by the etch time.

Dilute (no greater than 20%) molecular fluorine is preferably used. DOT regulations require pure fluorine to be shipped in cylinders with pressures no greater than 400 psig (2750 kPa). Using fluorine diluted with nitrogen or another inert gas decreases the hazards of fluorine, while maximizing the quantity of fluorine that can be shipped. This allows for the use of large quantities of fluorine for chamber cleaning without having the need for an onsite fluorine generator.

### Experiment I

In the first experiment, the reactor tube was maintained at 400⁰ C temperature and with 30 torr (4 kPa) pressure. Different concentrations of pre-diluted F₂ in N₂ were introduced into the reactor tube. The results of thermal etch rate measurements for silicon nitride (SiNₓ) etched with pre-diluted F₂ in N₂ as a function of F₂ concentration are given in Table I.

**Table I Etch Rates for Silicon Nitride as a Function of F₂ Concentration**

| **%F2 in N2** | **Temperature (°C)** | **Pressure (torr (kPa))** | **Etch Rate (nm/min)** |
|---|---|---|---|
| 2.5 | 400 | 30(4) | 17 |
| 5 | 400 | 30 (4) | 29 |
| 20 | 400 | 30 (4) | 155 |

The results show that the dilute (no greater than 20%) molecular fluorine has a low thermal activation temperature. The F₂ reacts with the silicon nitride to form SiF₄ that can be pumped from the chamber. The etch rates are 17 nm/min for 2.5% F₂, 29 nm/min for 5% F₂ and 155 nm/min for 20% F₂. The results show that the etch rate increases as the F₂ concentration increases at the fixed temperature and pressure. The results further show that even at a very low concentration of 2.5% F₂, the etch rate is 0.017 µm /min at 400° C, which is comparable with the etch rate of 0.02 µm /min from 20% NF₃ at 550⁰ C.

### Experiment II

To further determine the thermal etch rate of silicon nitride by pre-diluted 20 % F₂ in N₂, a design of experiment (DOE) study was carried out. The DOE study covered a temperature range of 230 °C to 511 °C and a pressure range of 10 to 103 torr (1.3 to 13.7 kPa). A total of 12 silicon nitride etch rates were determined at various temperatures and pressures.

The thermal etch rate measurements for silicon nitride etched with pre-diluted 20% F₂ at various temperatures and pressures are given in Table II. The results again show that the dilute (no greater than 20%) molecular fluorine has the low thermal activation temperature, etching of silicon nitride occurs even at a low temperature such as 230 °C.

**Table II Etch Rates for Silicon Nitride**

| **Experimental Run** | **Temperature (°C)** | **Pressure (torr (kPa))** | **Etch Rate (nm/min)** |
|---|---|---|---|
| 1 | 230 | 51.5 (6.87) | 11.2 |
| 2 | 231 | 101 (13.5) | 17.6 |
| 3 | 234 | 10.3 (1.37) | 6.6 |
| 4 | 262 | 103 (13.7) | 60.2 |
| 5 | 374 | 100 (13.3) | 236.9 |
| 6 | 378 | 55.8 (7.44) | 139.7 |
| 7 | 403 | 31 (4.13) | 290.9 |
| 8 | 404 | 30.5 (4.07) | 271.2 |
| 9 | 405 | 30.4 (4.05) | 205.9 |
| 10 | 510 | 100 (13.3) | 770.3 |
| 11 | 511 | 10 (1.33) | 629.2 |
| 12 | 511 | 51.8 (6.91) | 713.1 |

The data shows that the etch rate is strongly dependent on temperature and, to a lesser extent, pressure. The etch rate is relatively low below 300 °C and increases rapidly to >600 nm/min at 500 °C and 100 torr (13.3 kPa).

### Experiment III

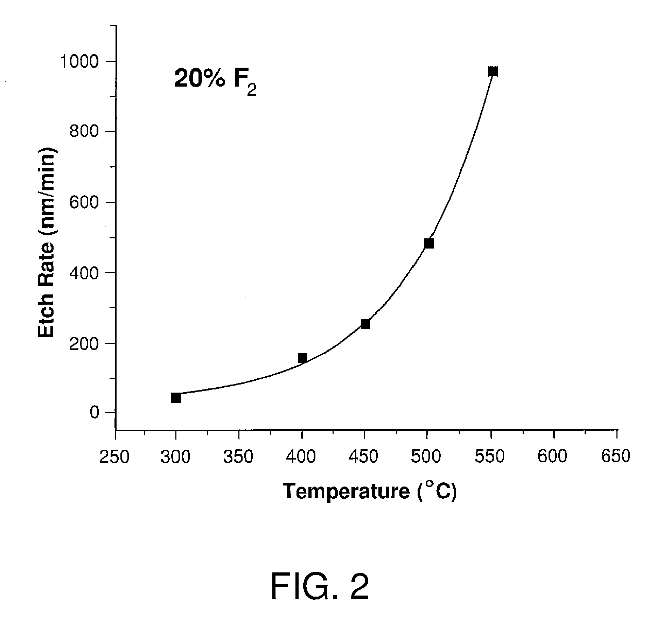

Based on the second experiment, the etch rate with pre-diluted 20% F₂ at various temperatures with a fixed pressure was further investigated. In this experimental set, a series of thermal etch rate experiments were carried out with 20% F₂ in N₂ at 30 torr (4 kPa) with temperatures ranging from 300 °C to 550 °C. The experimental data of the etch rate versus temperature is plotted in Figure 2.

The etch rates for 20% F₂ are 53 nm/min at 300⁰ C, 139 nm/min at 400° C, and increasing rapidly to 965 nm/min at 550⁰ C. The data shows that the etch rate increases exponentially as the temperature increases, as evidenced by the solid best fit line in Figure 2.

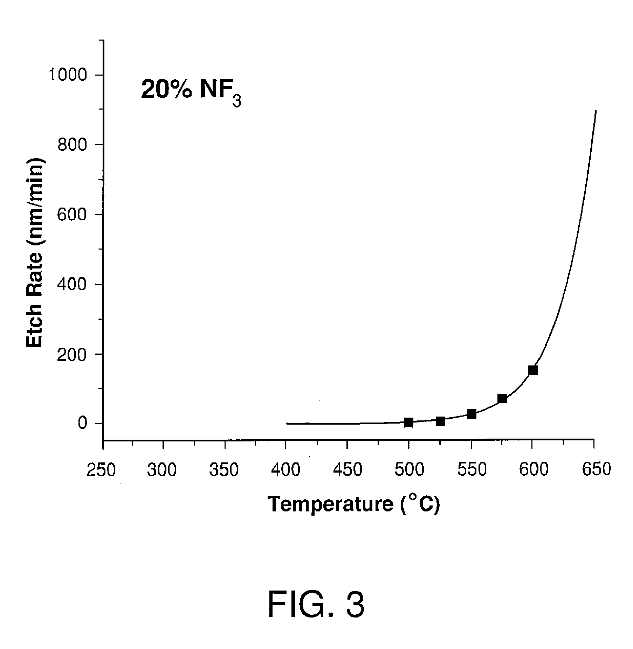

Figure 3 is a graph showing the thermal NF₃ etch rate of silicon nitride films deposited with BTBAS by pre-diluted 20% NF₃ in N₂ as a function of temperatures ranging from 500 °C to 600 °C at 30 torr (4 kPa). The data is extracted from Figure 1 in D. Foster, J. Ellenberger, R.B. Herring, A.D. Johnson, and C.L. Hartz, "In-situ process for periodic cleaning of low temperature nitride furnaces," in Proceedings of the 204th Meeting of the Electrochemical Society, Orlando FL (The Electrochemical Society, Inc., Pennington, NJ, October 2003) p. 285-293.

While the silicon nitride etch rate for 20% NF₃ also shows an exponential increase, as evidenced by the solid best fit line in Figure 3, the window of this increase for 20% NF₃ (∼580 ⁰C) is approximately 200 degrees higher than for 20% F₂ (-370 ⁰C). This is significant since the next generation silicon nitride deposition processes will take place at temperatures considerably below 580 ⁰C.

As indicated by the graph in Figure 3, the thermal 20% NF₃ etch rates are considerably lower than the thermal 20% F₂ etch rates (shown in Figure 2) in the temperature range from 300 to 600 ⁰C. For example, at 500 ⁰C and 30 Torr (4 kPa), the 20% NF₃ etch rate (∼2 nm/min) is more than two orders of magnitude lower than the 20% F₂ etch rate (∼500 nm/min) at the same temperature and pressure.

The experimental results show that the dilute (no greater than 20%) molecular fluorine has much lower thermal activation temperature and higher etching rates. Therefore, the dilute (no greater than 20%) molecular fluorine provides more efficient cleaning of equipment surfaces of undesired silicon nitride in semiconductor processing chambers at lower thermal activation temperatures in the range of 300 °C to 600 °C.

### Experiment IV

To assess the potential damage that etching can cause to quartz reactors, experiments were carried out examining the effects of 20% F₂ and 100%NF₃ on quartz under the conditions of Example II. Weight loss and surface degradation of flame polished quartz (SiO₂) were measured following thermal F₂ and NF₃ exposure. These measurements provide an estimate of nitride selectivity and illustrate the potential for damage to the quartz reactors by 20% F₂ and 100% NF₃.

A summary of the results is given in the Table IV. All quartz samples were etched for 20 minutes except for the sample etched with fluorine at 550 °C which was etched for 10 minutes. Upon visual inspection, quartz pieces etched with 20% fluorine exhibited appearances ranging from smooth and slightly hazy for the sample etched at 400 °C to very hazy for the sample etched at 550 °C. Alternatively, etching with 100% NF₃ causes discoloration of the quartz pieces (leaving them with a brownish appearance) in addition to causing them to become hazy. This quartz etch rate data coupled with the silicon nitride etch rate data above indicate that the non-desired etching of quartz is similar for 20% F₂ at 400⁰ C as it is for 100% NF₃ at 550⁰ C, while the etch rate for silicon nitride is much higher for 20% F2.

**Table IV. Etch rate and surface degradation of flame polished quartz following thermal F₂ and NF₃ exposure.**

| **Etch Gas** | **Temp** | **Pressure** | **% Etch Rate** | **Visual Surface Damage** |
|---|---|---|---|---|
| | (deg C) | (torr (kPa)) | (% mass loss/min) | |
| Blank | n/a | n/a | n/a | smooth & clear appearance |
| F2 | 550 | 50 (6.7) | 0.496 | very hazy but no discoloration |
| F2 | 400 | 50 (6.7) | 0.045 | slightly hazy but no discoloration |
| NF3 | 550 | 100 (13) | 0.023 | hazy and brownish discoloration |
| NF3 | 550 | 10 (1.3) | 0.042 | slightly hazy and brownish discoloration |

While specific embodiments have been described in detail, those with ordinary skill in the art will appreciate that various modifications and alternatives to those details could be developed in light of the overall teaching of the disclosure. Accordingly, the particular arrangements disclosed are meant to be illustrative only and not limiting to the scope of the invention.

## Claims

1. A thermal process for cleaning equipment surfaces of undesired silicon nitride in a semiconductor processing chamber using fluorine, comprising:
(a) flowing fluorine diluted in an inert gas through the chamber;
(b) maintaining the chamber at an elevated temperature of 230 °C to 565 °C to thermally disassociate the fluorine, thereby cleaning undesired silicon nitride from the surfaces by chemical reaction of thermally disassociated fluorine in (b) with the undesired silicon nitride to form volatile reaction products; and
(c) removing the volatile reaction products from the chamber.

2. The process of Claim 1 wherein the pre-diluted fluorine has a fluorine concentration of no greater than 20%.

3. The process of any preceding claim wherein the inert gas is selected from nitrogen, argon, helium and mixtures thereof.

4. The process of any preceding claim further comprising maintaining the chamber pressure in the range of 10 to 101 torr (1.3 to 13.5 kPa).

5. The process of any preceding claim wherein the silicon nitride is silicon nitride deposited from the reaction of an organic amine substituted silane and/or organic substituted silane with ammonia.

6. The process of Claim 5 wherein:
the organic amine substituted silane is selected from bis-tertiary butyl amine silane, diisopropyl amine silane , and diethyl amine silane; and/or
the organic substituted silane is selected from tetra allyl silane, and trivinyl silane with bis-tertiary butyl amino silane.

7. The process of any one of Claims 1 to 4 wherein the silicon nitride is silicon nitride deposited from the reaction of dichloro-silane with ammonia.

8. The process of any preceding claim, wherein the chamber is maintained at an elevated temperature of 450 to 550°C to thermally disassociated the fluorine.
